# EUROPÄISCHE PATENTANMELDUNG

(11) **EP 4 790 737 A1**
(43) Veröffentlichungstag der Anmeldung: **12.08.2026**
(21) Anmeldenummer: 26154971.1
(22) Anmeldetag: 29.01.2026
(51) Int. Cl.: H01H 9/54, H02H 7/08, H02P 7/03, H03K 17/687

(54) **LADEBRÜCKENSTEUERUNG SOWIE VERFAHREN ZUM STEUERN EINER LADEBRÜCKE**

(30) Priorität: 07.02.2025 DE 102025104655; 05.03.2025 DE 102025108427
(71) Anmelder: Hörmann KG Antriebstechnik, 33803 Steinhagen (DE)
(72) Erfinder: Mittmann, Steffen, 49074 Osnabrück (DE); Müller, Alexander, 33619 Bielefeld (DE)
(74) Vertreter: KASTEL Patentanwälte PartG mbB

(57) **Zusammenfassung**

Zur Verbesserung eines zuverlässigen Schaltens wird eine Ladebrückensteuerung (14) vorgeschlagen zum Steuern einer Ladebrücke (12), welche einen Elektromotor (22) aufweist, wobei die Ladebrückensteuerung (14) einen Prozessor (28) aufweist und dazu eingerichtet ist, Bewegungsabläufe der Ladebrücke (12) in Abhängigkeit von Benutzereingaben zu steuern, und eine Schalteinrichtung (34) zum Ein- und Ausschalten des Elektromotors (22) aufweist, wobei die Schalteinrichtung (34) einen Halbleiterschalter (38) mit antiseriell verschalteten Leistungstransistoren (Q1, Q2) aufweist.

## Beschreibung

### Die Erfindung betrifft

Zum technologischen Hintergrund, zum Stand der Technik und zur Verdeutlichung von Einzelheiten möglicher Ausführungsformen der Erfindung wird auf folgende Literaturstellen verwiesen:
[1] "VERLADETECHNIK" - Firmenbroschüre der Hörmann KG Verkaufsgesellschaft mit dem Druckvermerk Stand 12.2023 / Druck 12.2023 / HF 86278 DE / SAP 368783 / G.XX / Gedruckt auf 100 % Recyclingpapier, heruntergeladen am 06.02.2025 unter https://www.hoermann.de/mediacenter/download/205067de/Verladetechni k.pdf?20241213084308
[2] "Anleitung für Montage und Betrieb HLS-2 / HTL-2" - Firmenbroschüre der Hörmann KG Verkaufsgesellschaft mit dem Druckvermerk 1004190 / 01.2010, heruntergeladen am 06.02.2025 unter https://www.hoermann.de/mediacenter/download/207320de/Anleitung_La debruecke_HLS2_HTL2_1004190_DE_1.pdf?20240123202212
[3] "Anleitung für Montage, Betrieb und Wartung- HTLV4" - Firmenbroschüre der Hörmann KG Verkaufsgesellschaft mit dem Druckvermerk 1200018550 / 09.2023, heruntergeladen am 06.02.2025 unter https://www.hoermann.de/mediacenter/download/267012de/Anleitung_HT LV4_1200018550_09.2023_DE.pdf?20240126094506
[4] "Anleitung für Montage, Betrieb und Wartung - Steuerung für Ladebrücken - 420 S / 420 T - 420 Si / 420 Ti" - Firmenbroschüre der Hörmann KG Verkaufsgesellschaft mit dem Druckvermerk TR25E789, heruntergeladen am 06.02.2025 unter https://www.hoermann.de/mediacenter/download/188590de/TR25E789_K ombiSteuerung_Ladebr_420_S_T_420_Si_Ti_DE.pdf?20240604132423

Aus [2] und [3] sind unterschiedliche Ladebrücken bekannt. [4] zeigt Ladebrückensteuerungen zum Steuern der aus [2] und [3] bekannten Ladebrücken. Die Ladebrücken weisen einen elektrohydraulischen Ladebrückenantrieb mit Ventilen und einer Hydraulikpumpe mit Elektromotor auf. Die Ladebrückensteuerung weist einen Prozessor auf und ist dazu eingerichtet, den Ladebrückenantrieb anzusteuern, um so Bewegungsabläufe der Ladebrücke in Abhängigkeit von Benutzereingaben zu steuern. Dabei weist die Ladebrückensteuerung eine Schalteinrichtung zum Ein- und Ausschalten des Elektromotors auf. Der Elektromotor ist insbesondere als Drehstrommotor ausgebildet. Dieser muss durch die Schalteinrichtung zuverlässig ein- und ausgeschaltet werden. Hierzu weist die Schalteinrichtung der aus [4] bekannten Ladebrückensteuerungen eine Hintereinanderschaltung von zwei Schützen auf.

Die Erfindung hat sich zur Aufgabe gestellt, eine Ladebrückensteuerung hinsichtlich zuverlässigen Schaltens eines Elektromotors einer Ladebrücke zu verbessern.

Zum Lösen dieser Aufgabe schafft die Erfindung eine Ladebrückensteuerung nach Anspruch 1. Eine damit versehene Ladebrückenanordnung sowie ein Betriebsverfahren sind Gegenstand der Nebenansprüche.

Vorteilhafte Ausgestaltungen sind Gegenstand der Unteransprüche.

Die Erfindung schafft gemäß einem Aspekt davon eine Ladebrückensteuerung zum Steuern einer Ladebrücke, welche einen Elektromotor aufweist, wobei die Ladebrückensteuerung einen Prozessor aufweist und dazu eingerichtet ist, Bewegungsabläufe der Ladebrücke in Abhängigkeit von Benutzereingaben zu steuern, und eine Schalteinrichtung zum Ein- und Ausschalten des Elektromotors aufweist, wobei die Schalteinrichtung einen Halbleiterschalter mit antiseriell verschalteten Leistungstransistoren aufweist.

Bei einigen Ausführungsformen ist vorgesehen, dass die Ladebrückensteuerung dazu eingerichtet ist, die Funktion des Halbleiterschalter vor oder nach jeder Betätigung desselben zu überprüfen.

Bei einigen Ausführungsformen ist vorgesehen, dass eine Überprüfungseinrichtung zur Funktionsüberprüfung des Halbleiterschalters vorgesehen ist, die einen Spannungssensor zum Messen einer Spannung an dem Halbleiterschalter und/oder einen Stromsensor zum Messen eines durch den Halbleiterschalter laufenden Stroms aufweist.

Bei einigen Ausführungsformen ist vorgesehen, dass die Ladebrückensteuerung weiter dazu eingerichtet ist, nach festgestellter Fehlfunktion automatisch ein erneutes Betätigen des Halbleiterschalters zu verhindern.

Bei einigen Ausführungsformen ist vorgesehen, dass die antiseriell verschalteten Leistungstransistoren back-to-back verschaltete n-Kanal-Mosfets sind.

Bei einigen Ausführungsformen ist vorgesehen, dass für jede Phase des Elektromotors ein Halbleiterschalter mit antiseriell verschalteter Leistungstransistoren vorgesehen sind.

Bei einigen Ausführungsformen ist vorgesehen, dass der Halbleiterschalter eine Treiberschaltung für die Leistungstransistoren mit einem durch den Prozessor betätigbaren Schalter aufweist.

Bei einigen Ausführungsformen ist vorgesehen, dass einer der antiseriell verschalteten Leistungstransistoren mit einer Wechselstromquelle verbunden ist.

Bei einigen Ausführungsformen ist vorgesehen, dass der andere der antiseriell verschalteten Leistungstransistoren mit der zugeordneten Phase des Elektromotors verbunden ist.

Bei einigen Ausführungsformen ist vorgesehen, dass die Treiberschaltung einen Kondensator aufweist, der parallel zu dem Schalter geschaltet ist.

Bei einigen Ausführungsformen ist vorgesehen, dass die Treiberschaltung eine erste Diode aufweist, die parallel zu dem Schalter und/oder dem Kondensator geschaltet ist. Bei einigen Ausführungsformen ist vorgesehen, dass die Treiberschaltung einen Widerstand und eine zweite Diode aufweist, wobei der Widerstand und die entgegengerichtet zu der ersten Diode wirkende zweite Diode in Serie zwischen einem Eingang des Schalters und einem Neutralleiter geschaltet sind.

Bei einigen Ausführungsformen ist vorgesehen, dass die Treiberschaltung der Eingang des Schalters mit den Gates der Leistungstransistoren verbunden ist und der Ausgang des Schalters mit der Verbindungsleitung zwischen den Leistungstransistoren verbunden ist.

Gemäß einem weiteren Aspekt schafft die Erfindung eine Ladebrückenanordnung, umfassend eine Ladebrücke mit einem Ladebrückenantrieb, der einen Drehstrommotor umfasst, und eine Ladebrückensteuerung nach einem der voranstehenden Ansprüche.

Ausführungsformen der Ladebrücke samt deren Antrieb gehen insbesondere in allen Einzelheiten aus [1], [2] und [3] hervor. Es wird für weitere Einzelheiten zum möglichen Aufbau der Ladebrücke, insbesondere deren Antrieb, der Ausbildung des Motors und der Pumpe, der Verschaltung der Ventile usw. auf [2] und [3] verwiesen.

Für weitere Einzelheiten zum Aufbau der Ladebrückensteuerung wird auf [4] verwiesen. Mögliche Ausführungsformen der Erfindung ergeben sich ausgehend von der Ladebrückensteuerung gemäß [4] durch Austausch der dort vorgesehenen Schalteinrichtung für den Drehstrommotor mit der hier Schalteinrichtung gemäß der Ausführungsbeispielen der Erfindung. Weitere Modifikationen bevorzugter Ausführungsbeispiele gegenüber der aus [4] bekannten Ladebrückensteuerung werden hiernach noch beschrieben.

Gemäß einem weiteren Aspekt Verfahren zum Betrieb einer Ladebrücke, die durch einen Ladebrückenantrieb, der einen Drehstrommotor umfasst, angetrieben wird, wobei der Ladebrückenantrieb durch eine Ladebrückensteuerung nach einer der voranstehenden Ausgestaltungen gesteuert wird, wobei der Drehstrommotor mittels des Halbleiterschalters mit einer Wechselstromquelle verbunden wird und davon getrennt wird.

Ausführungsformen der Erfindung betreffen einen zuverlässiger Halbleiterschalter zur Ansteuerung von Drehstromverbrauchern einer elektrohydraulisch betriebenen Verladebrücke.

Mit dem Halbleiterschalter wird insbesondere ein Drehstrommotor zuverlässig ein-und ausgeschaltet.

Bisher wird für diese Aufgabe eine Hintereinanderschaltung von zwei Schützen eingesetzt. Sollte ein Schütz nicht zuverlässig schalten, wird auf die Funktionsfähigkeit des zweiten Schützes vertraut. Die Zustände der zwei Schütze werden nicht überwacht.

Eines der beiden Schütze muss die Last schalten. Durch das Schalten unter Last kommt es zu Verschleiß am jeweiligen Schütz. Sobald es zu Unregelmäßigkeiten beim Schalten kommt, muss das zweite Schütz in der redundanten Anordnung den Schaltvorgang übernehmen. In diesem Moment ist das Lebensdauerende der Steuerung erreicht. Ein Austausch der Schütze und damit auch der gesamten Steuerungsplatine ist nötig.

Ein weiterer Nachteil besteht in der Verfügbarkeit von Printschützen. Schütze der Gebrauchskategorie AC3, die Lasten im unteren Kilowattbereich schalten können und zugleich für die Durchsteckmontage auf einer Leiterplatte vorgesehen sind, werden nur von wenigen Herstellern angeboten. Es ergeben sich Nachteile hinsichtlich der Bereitstellung und des Preises.

Ausführungsbeispiele der Erfindung haben eine Schaltung, die durch Überwachung der Schaltelemente sicher betrieben werden kann. Als Schaltelemente kommen Transistoren sowie Relais zum Einsatz. Über die Transistoren kann der Stromfluss zwischen zwei Zuständen umgeschaltet werden: Strom = 0 ("sperrend") oder Strom = beliebig ("leitend"). Sofern ein Transistor defekt ist (dauerhaft leitend oder dauerhaft sperrend), kann trotzdem der Zustand Strom = 0 erreicht werden. Über die Relais wird Spannungsfreiheit hergestellt. Die Funktionsfähigkeit von Relais und Transistoren wird vor und/oder nach jedem Schaltzyklus festgestellt und wenn nötig, werden weitere Schaltzyklen verhindert.

Besondere Vorteile liegen in der Realisierung der Schaltung bevorzugter Ausgestaltungen der Erfindung. Die Ansteuerung der Transistoren ist robust und diskret aufgebaut, so dass nicht auf spezielle Treiberbausteine zurückgegriffen werden muss. Ferner wurde darauf geachtet, dass beliebige N-Kanal Transistoren der angemessenen Leistungsklasse verwendet werden können. Die Überwachungsschaltungen sind derart ausgelegt, dass möglichst wenig Verlustleistung erzeugt wird.

Die speziellen Schütze werden durch Halbleiter ersetzt, die in ähnlicher Ausführung von einer Vielzahl an Herstellern angeboten werden. Da es sich bei Schützen um mechanische Bauelemente handelt, ist in Zukunft nicht mit einer deutlichen Preissenkung zu rechnen. Aufgrund der stetigen Entwicklung im Bereich der Herstellungsprozesse bei Halbleitern ist aber eine Preissenkung bei Transistoren zu erwarten.

Weitere Vorteile sind, dass es kaum noch zu Verschleiß kommt, da die Transistoren die Last schalten; außerdem ist das Ein- und Ausschalten zu präzisen Zeitpunkten (= Phasenlage der Netzspannung) möglich. Dadurch ist mitunter ein besseres Verhalten hinsichtlich der Störemission und des Anlaufverhalten des Motors zu erwarten.

Gewicht und Bauvolumen verringern sich um ein Vielfaches. Schütze erfordern aufgrund ihres hohen Gewichts eine ausreichend stabile und gut befestigte Platine. Aufgrund des deutlich geringeren Gewichts - weniger Massenträgheit - der vorgestellten Lösung sind einfachere Befestigungsmaßnahmen der Platine im Gehäuse möglich. Anstatt von Schrauben sind Rastnasen oder Clipse denkbar.

Auch hinsichtlich der Funktionsbreite ergeben sich Verbesserungen, z.B. hinsichtlich des Motorlaufs. Denkbar ist ein kontrollierter Motoranlauf, der realisiert wird, indem die Transistoren eine Modulation erfahren (z. B. Auslassen von ganzen Perioden).

Ein Ausführungsbeispiel wird im Folgenden anhand der beigefügten Zeichnungen näher erläutert. Darin zeigt:
- Fig. 1: eine teils schematische Vorderansicht einer Ladebrückenanordnung mit einer Ladebrücke und einer Ladebrückensteuerung;
- Fig. 2: eine schematische Blockansicht eines Motors eines Ladebrückenantriebs der Ladebrücke sowie einer Schalteinrichtung der Ladebrückensteuerung zum Schalten des Motors, wobei die Schalteinrichtung als Halbleiterschalter mit Überwachungseinrichtung ausgebildet ist;
- Fig. 3: eine schematische Blockdarstellung eines Teils des Halbleiterschalters zum Schalten einer Phase des Motors;
- Fig. 4: ein Blockschaltbild eines Paars antiseriell verschalteter Leistungstransistoren des in Fig. 3 gezeigten Teils des Halbleiterschalters während einer positiven Halbschwingung der Versorgungsspannung;
- Fig. 5: das Blockschaltbild von Fig. 4 während einer negativen Halbschwingung der Versorgungsspannung;
- Fig. 6: ein Schaltbild des Halbleiterschalters zum Schalten einer Phase des Motors, wobei die antiseriell verschalteten Leistungstransistoren und eine Treiberschaltung dargestellt sind;
- Fig. 7: das Schaltbild von Fig. 6 während einer positiven Halbschwingung, wobei die Leistungstransistoren sperren;
- Fig. 8: das Schaltbild von Fig. 6 während einer negativen Halbschwingung, wobei die Leistungstransistoren sperren;
- Fig. 9: das Schaltbild von Fig. 6 während einer positiven Halbschwingung, wobei die Leistungstransistoren leiten;
- Fig. 10: das Schaltbild von Fig. 6 während einer negativen Halbschwingung, wobei die Leistungstransistoren leiten; und
- Fig. 11: ein Spannungs-Zeitdiagramm einer Periode der Netzspannung zum Darstellen einer positiven Halbschwingung und einer negativen Halbschwingung.

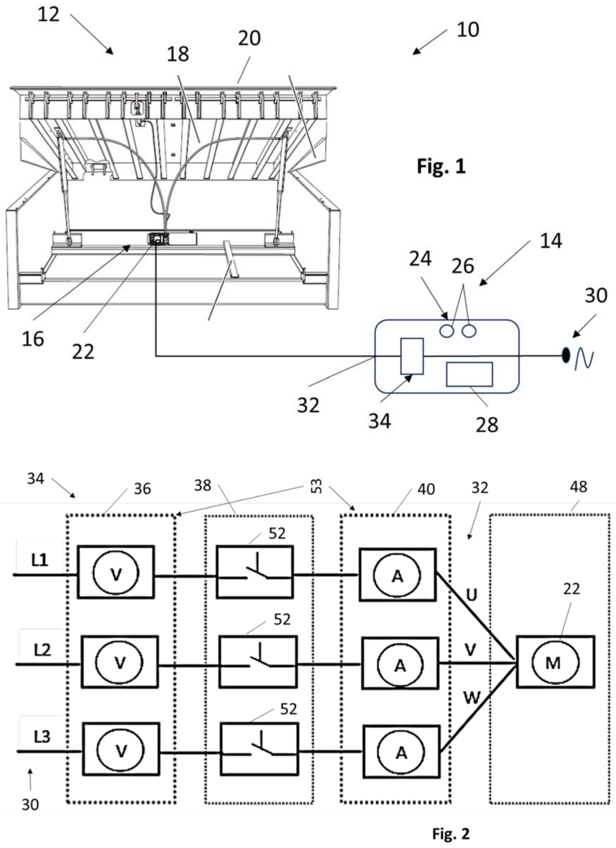

In Fig. 1 ist teils schematisch eine Ladebrückenanordnung 10 mit einer Ladebrücke 12 und einer Ladebrückensteuerung 14 dargestellt. Die Ladebrücke 12 ist in dem Beispiel als Klappkeilladebrücke dargestellt, kann aber auch eine Vorschubladebrücke sein. Die Ladebrücke 12 ist bei einigen Ausführungsformen so ausgebildet, wie dies im Einzelnen in den Literaturstellen [2] oder [3] gezeigt ist, worauf für weitere Einzelheiten verwiesen wird. Wie dies im Einzelnen einschließlich Figuren und Hydraulikschaltkreis aus [2] und [3] hervorgeht, weist die Ladebrücke 12 einen elektrohydraulischen Ladebrückenantrieb 16 auf, mittels der eine Plattform 18 und eine Lippe 20 der Ladebrücke 12 bewegt werden. Der Ladebrückenantrieb 16 weist insbesondere eine Hydraulikpumpe mit Elektromotor 22 auf. Der Elektromotor 22 ist als Drehstrommotor ausgebildet und weist Anschlüsse für die drei Phasen u, v, w auf.

Die Ladebrückensteuerung 14 ist in Fig. 1 nur schematisch dargestellt. Bei einigen Ausführungsformen ist die Ladebrückensteuerung 14 so ausgebildet, wie dies bis auf die im Folgenden näher erläuterten Modifikationen aus der Literaturstelle [4] hervorgeht. Wie in [4] genauer gezeigt und beschrieben, weist die Ladebrückensteuerung 14 eine Benutzerschnittstelle 24 mit Tasten oder dergleichen Bedienelementen 26 und einer Anzeigeeinrichtung, eine Platine mit einem Prozessor 28 und einem Speicher, in der Programme für den Steuerungsablauf gespeichert sind, Anschlüsse für Ventile, Anschlüsse für Peripheriegeräte, einen Versorgungsspannungsanschluss 30 für Drehstrom mit drei Außenleiter L1, L2, L3, einen Motoranschluss 32 zum Anschließen des Elektromotors 22 und eine Schalteinrichtung 34 auf, mit der der die einzelnen Phasen u, v, w des Motoranschlusses 32 zum Einschalten des Elektromotors 32 mit den Außenleiter L1, L2, L3 des Versorgungsspannungsanschlusses verbindbar sind.

Die Schalteinrichtung 34 ist durch den Prozessor 28 entsprechend den Vorgaben der Steuerungsabläufe in Abhängigkeit von Benutzereingaben ansteuerbar.

Im Folgenden wird der Aufbau eines bevorzugten Ausführungsbeispiels der Schalteinrichtung 34 anhand der Darstellung der Fig. 2 bis 11 näher erläutert.

Die Schalteinrichtung 34 ist bei einigen Ausführungsbeispielen als Back-to-Back-Schaltung für Wechselstromanwendungen ausgeführt.

Für den Betrieb der Ladebrücke 12 ist es, wie bei einigen vergleichbaren Anwendungen, erforderlich, den Elektromotor 22 oder einen vergleichbaren Verbraucher, der an einem Dreh- oder Wechselstromnetz betrieben wird, zuverlässig ein- und auszuschalten. Mechanische Schütze können für diese Aufgabe verwendet werden und stellen den Stand der Technik dar. Die im Folgenden vorgestellte Schaltung verwendet Halbleiter anstatt mechanischer Komponenten. Sie hat die Fähigkeit, Wechselstrom effizient und zuverlässig zu schalten.

In Fig. 2 wird das Gesamtkonzept vorgestellt, das Spannungsmessung - Spannungssensor 36 -, Halbleiterschalter 38, Strommessung - Stromsensor 40 und Last 48 - hier der Elektromotor 22, mit seinen Phasen u, v, w - beinhaltet. In bereits bekannten Leistungsschaltern, die auf Halbleitern basieren, werden Thyristoren oder Triacs verwendet. Handelt es sich um einen Stromrichter mit DC-Zwischenkreis werden MOSFETs, Bipolartransistoren oder IGBTs verwendet. Bei der hier vorgestellten Schaltung handelt es sich um einen Leistungsschalter ohne DC-Zwischenkreis, der dennoch MOSFETs als Leistungshalbleiter - Leistungstransistor Q1, Q2 - verwendet. Vorteilhaft bei der Schaltung ist die bewusste Nutzung der Bodydiode 44 der eingesetzten MOSFETs 46. Dieses Prinzip hiernach noch genauer erläutert.

Vergleichbare Schaltungen werden bisher hauptsächlich zum Schalten von Lasten in DC-Anwendungen benutzt. Bei Ausführungsbeispielen der Erfindung werden dagegen Back-to-Back-Schaltung verschaltete MOSFETs 46 zum Schalten von Wechselspannungen eingesetzt.

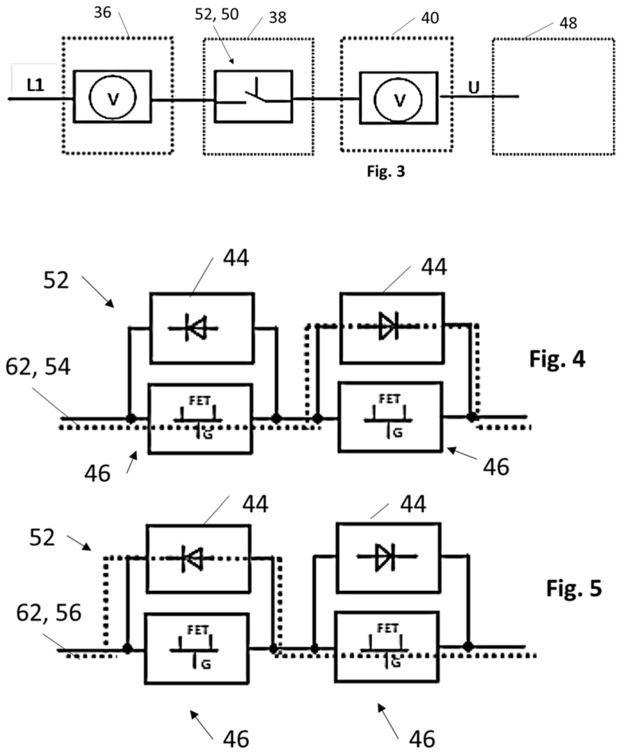

In Fig. 3 ist ein Auszug der Schalteinrichtung 34 mit dem für das Schalten der ersten Phase L1, u zuständigen Zweig dargestellt. Im Folgenden wird aus Darstellungsgründen nur einen der drei Zweige Bezug genommen, die anderen Zweige zum Schalten der anderen Phasen L2, v; L3, w sind vergleichbar aufgebaut.

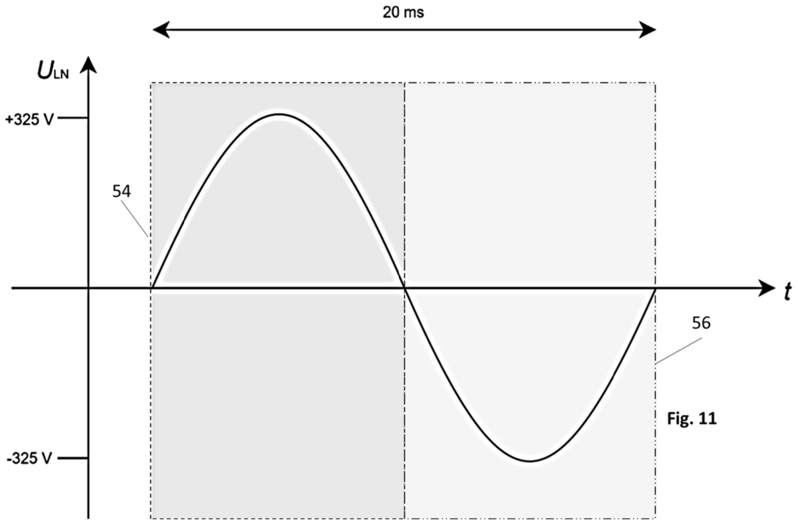

Fig. 4 zeigt die antiserielle Verschaltung der Leistungstransistoren Q1, Q2 des jeweiligen Teils des Halbleiterschalters 38 bei einer positiven Halbschwingung 54 der Versorgungsspannung, wie sie gestrichelt umrahmt in Fig. 11 dargestellt ist. Fig. 5 zeigt die Schaltung von Fig. 4 bei einer negativen Halbschwingung 56 der Versorgungsspannung, wie sie gestrichelt mit Doppelpunkten umrahmt in Fig. 11 dargestellt ist.

Die hier eingesetzte und in Fig. 4 und 5 gezeigte Back-to-Back-Schaltung 52 wird mit MOSFETs 46 realisiert, die so geschaltet sind, dass sie in entgegengesetzter Richtung leiten können. Diese Konfiguration wird verwendet, um bidirektionale Stromflüsse zu ermöglichen und gleichzeitig eine hohe Effizienz und geringe Verluste zu gewährleisten.

Ein beispielhafter Aufbau ist wie folgt: Es werden MOSFETs 46 in Serie angeordnet. Zwei N-Kanal-MOSFETs 46 werden in Serie geschaltet, wobei die Source-Anschlüsse S miteinander verbunden sind. Die Drain-Anschlüsse D sind die Ein- und Ausgänge der antiseriellen Leistungstransistor-Schaltung. Die Gates G der MOSFETs werden durch eine geeignete Steuerschaltung - Treiberschaltung 50 - angesteuert, die sicherstellt, dass die Gate-Source-Spannung auf 0V gesetzt werden kann.

Vorteile derart antiseriell verschalteter Leistungstransistoren Q1, Q2 und insbesondere der gezeigten Back-to-Back-Schaltung 52 sind:
- **Bidirektionaler Stromfluss:** Diese Schaltung ermöglicht den Stromfluss in beide Richtungen, was besonders nützlich in Anwendungen wie Wechselrichtern und bidirektionalen Stromversorgungen ist.
- **Geringe Verluste:** MOSFETs 46 haben im eingeschalteten Zustand einen niedrigen Widerstand R_{Ds,on}, was zu geringen Leitungsverlusten führt.
- **Schnelle Schaltzeiten:** MOSFETs 46 können sehr schnell schalten, was die Effizienz der Schaltung weiter erhöht.

Die abgebildeten Messeinrichtungen 36, 38 für Strom und Spannung sind für die grundsätzliche Funktionalität der Back-to-Back Schaltung 52 nicht erforderlich.

Mit der Schalteinrichtung 34 soll bei einigen Ausführungsformen der Elektromotor 22 in Form eines Drehstromasynchronmotors angesteuert werden. Um die Schaltverluste gering zu halten, sollte zu geeigneten Zeitpunkten ein- sowie ausgeschaltet werden.

Zum Einschalten des Motors 22 eignet sich der Moment, in dem die Spannung, die über dem Halbleiterschalter 38 anliegt, 0 ist. Dadurch wird erreicht, dass Strom und Spannung im Einschaltmoment 0 sind und damit die Verlustleistung idealerweise ebenfalls 0 ist.

Da es sich bei einem Motor 22 um eine induktive Last handelt, ist die Stetigkeit des Stroms zu beachten. Besonders beim Abschalten kann Nichtbeachtung zu erhöhter Verlustleistung in den Schaltelementen oder Spannungsüberhöhung durch Induktion führen. Der Zeitpunkt, in dem der Strom gleich 0 ist, eignet sich daher, um den Schalter in den sperrenden Zustand zu überführen.

Mit dem Spannungssensor 36 und dem Stromsensor 40 lässt sich somit eine optimierte Schaltung mit geringen Verlusten erreichen. Außerdem können diese Sensoren 36, 40 Teil einer Überprüfungseinrichtung 53 sein, mittels der die Funktion des Halbleiterschalters 38 überwacht werden kann. Stimmen die von den Sensoren 36, 40 erfassten Werte nicht mit den bei dem eingestellten Schaltzustand zu erwartenden Werten überein, lässt sich eine Fehlermeldung generieren und ein weiterer Schaltmodus kann, falls notwendig, unterbunden werden.

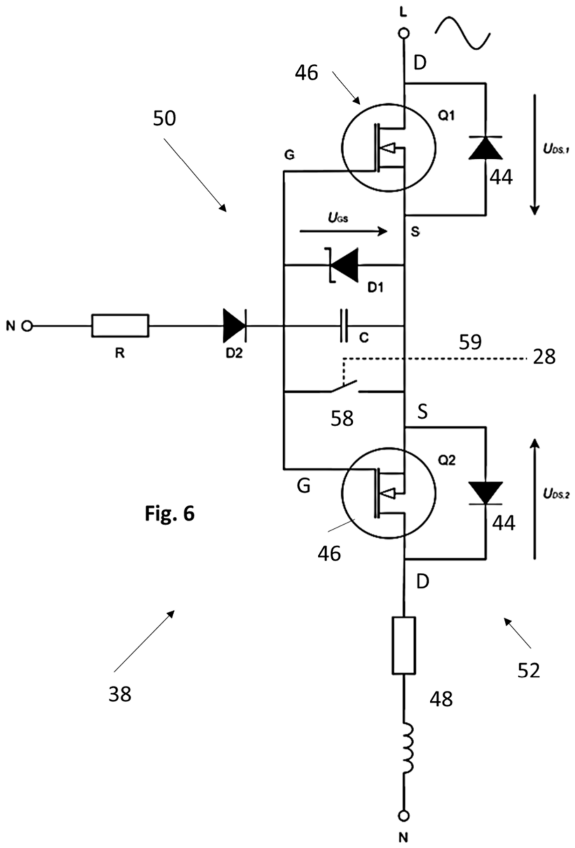

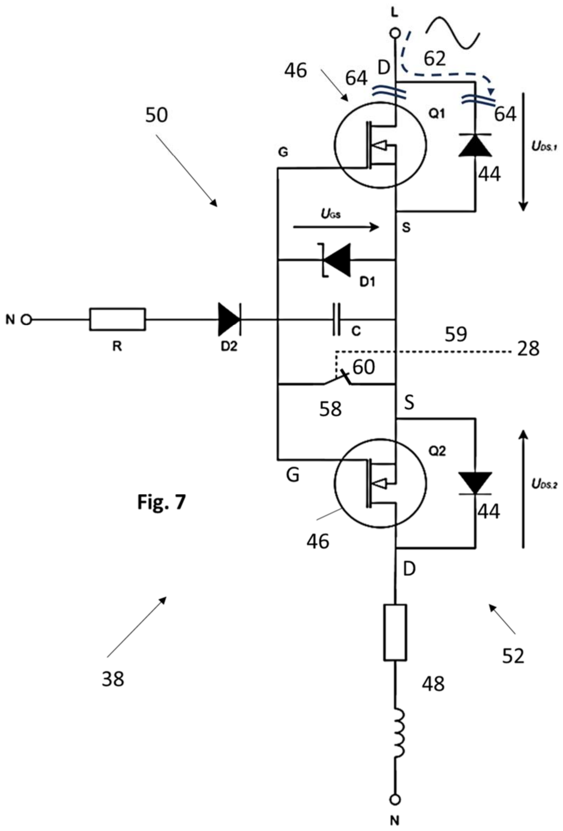

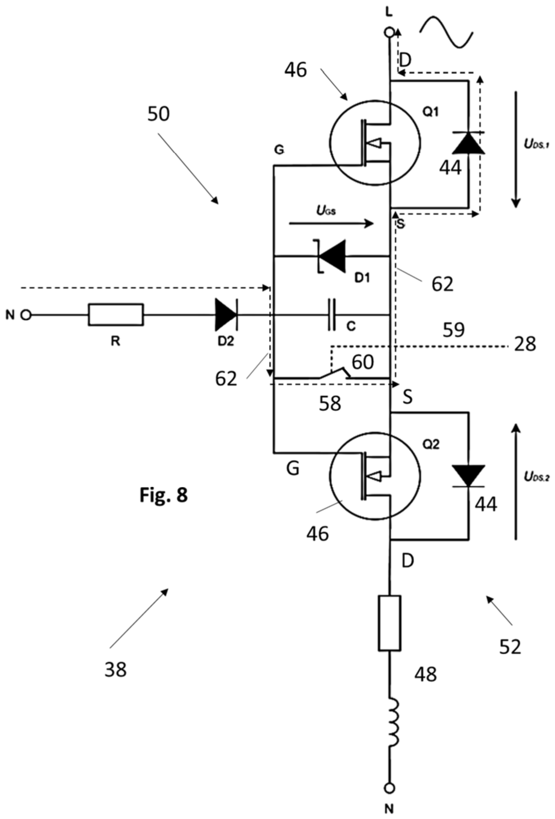

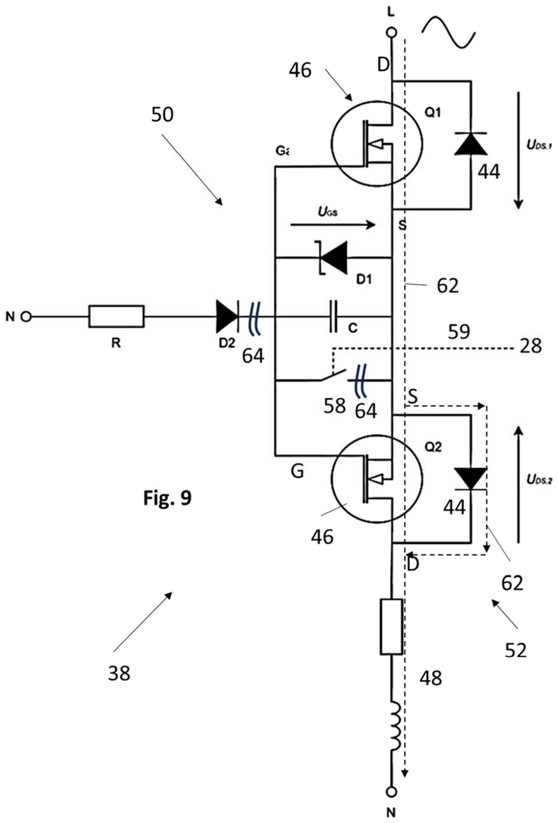

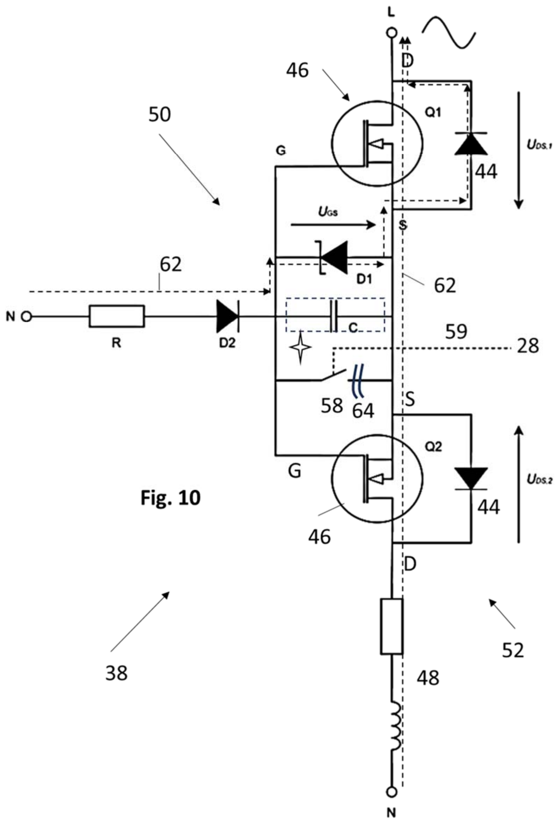

Details des Aufbaus der einzelnen Zweige des Halbleiterschalters 38 werden im Folgenden anhand der Figuren 6 bis 10 erläutert. Fig. 6 zeigt den Schaltungsaufbau. Fig. 7 erläutert deren Funktion bei einer positiven Halbschwingung 54, wenn die Leistungstransistoren Q1, Q2 sperren. Fig. 8 erläutert die Funktion bei einer negativen Halbschwingung 56, wenn die Leistungstransistoren Q1, Q2 sperren. Fig. 9 erläutert die Funktion bei einer positiven Halbschwingung 54, wenn die Leistungstransistoren Q1, Q2 leiten. Fig. 10 erläutert deren Funktion bei einer negativen Halbschwingung 56, wenn die Leistungstransistoren Q1, Q2 leiten.

Die Treiberschaltung 50 weist vorteilhaft einen Kondensator C auf, der bei leitenden Leistungstransistoren 42 bei einer der Halbschwingungen durch die Versorgungsspannung selbst aufgeladen wird und die Spannung für das Gate bereit stellt. Dadurch lässt sich der Halbleiterschalter 38 ohne zusätzlichen Niederspannungsanschluss betreiben. Ist der Kondensator C entladen, sperren die Leistungstransistoren Q1, Q2. Ein Schalter 58 ist parallel zum Kondensator C geschaltet. Ist der Schalter 58 geschlossen, wird der Kondensator C entladen, und ein Sperrzustand herbeigeführt.

Der Schalter 58 ist durch den Prozessor 28 betätigbar. Hierzu ist der Schalter 58 durch einen potentialfreien Kontakt (isolierte Verbindung 59) mit einem Ausgabeanschluss des Prozessors 28 verbunden.

Die Schaltung eines jeden Zweigs des Halbleiterschalters 38 wird nun detailliert beschrieben.

Um eine Last, die mit Wechselstrom oder Drehstrom betrieben wird, schalten zu können, werden üblicherweise Relais oder Schütze eingesetzt. Bei Ausführungsformen der Erfindung wird eine Schaltung beschrieben, die auf mechanische Komponenten verzichtet und Halbleiter verwendet.

Es sei ein Versorgungsnetz, z. B. 230 V AC, - angedeutet mit L in den Fig. 6 bis 10 als Abkürzung von L1, L2 oder L3, eine Last 48 (Elektromotor 22) und eine Steuerlogik - z.B. Prozessor 28 - gegeben. Der Halbleiterschalter 38 befindet sich zwischen L und der Last 48. Auf der anderen Seite ist die Last 48 mit dem Neutralleiter N verbunden, siehe Fig. 6.

Zum Schalten der Last 48 werden zwei N-MOS-Transistoren 46 verwendet. Diese als Q1 und Q2 bezeichneten Transistoren sind vom gleichen Typ und weisen eine interne Diode 44 auf. Bei dieser Diode 44, auch Bodydiode genannt, handelt es sich also nicht um ein diskretes Bauelement.

Die Transistoren Q1 und Q2 werden so verschaltet, dass die Gate- und Sourceanschlüsse G, S beider Transistoren Q1, Q2 miteinander verbunden werden. Beide Transistoren Q1, Q2 sehen daher dieselbe Spannung U_{GS}. Der Drainanschluss D des ersten Transistors Q1 ist mit dem Außenleiter L des Versorgungsnetzes verbunden. Der Drainanschluss D des zweiten Transistors Q2 ist mit der Last 48 verbunden.

Zwischen Gate und Source befindet sich eine Kapazität - Kondensator C -, eine erste Diode D1 - Zenerdiode - und der Schalter 58, der potenzialfrei von der Steuerlogik - Prozessor 28 - angesteuert werden kann. Die Zenerspannung der Zenerdiode D1 liegt etwas unter der maximal spezifizierten Gate-Source Spannung der Transistoren Q1, Q2. Der Schalter 58 kann die beiden Zustände leitend und sperrend annehmen. Das Gate G ist über eine zweite Diode D2 und einen Widerstand R mit dem Neutralleiter N verbunden.

Der gesamte Halbleiterschalter 38 kann zwei Zustände annehmen: leitend oder sperrend. Im leitenden Zustand kann Strom durch die Last 48 fließen. Im sperrenden Zustand kann kein Strom durch die Last 48 fließen.

Fig. 11, die eine Periode der Netzspannung zeigt, verdeutlicht die Funktionsweise dieser beiden Schaltzustände in Abhängigkeit von der Phasenlage der Netzspannung. Diese lässt sich in zwei Bereiche unterteilen. Erster Bereich 54: U_{LN} ist positiv. Zweiter Bereich 56: U_{LN} ist negativ. In Fig. 11 sind diese Bereiche 54, 56 gestrichelt umrandet (54) und mit Doppelpunkt gestrichelt umrandet (56).

In dem ersten Bereich der positiven Halbschwingung 54 ist die Bodydiode 44 des ersten Transistors Q1 nicht leitend. In dem zweiten Bereich der negativen Halbschwingung 56 ist die Bodydiode 44 des ersten Transistors Q1 leitend. Der Widerstand R wirkt wie eine Stromquelle.

Zur Analyse der Funktionsweise der in Fig. 6 gezeigten Schaltung ist es vorteilhaft, zunächst den Doppelpunkt-gestrichelten Bereich (U_{LN}<0; negative Halbschwingung 56) zu betrachten.

Wenn der Halbleiterschalter 38 sperren soll, muss der Schalter 58 zwischen Gate G und Source S leitend sein. Fig. 8 verdeutlicht diesen Schaltzustand 60. Die Spannung U_{GS} beträgt 0 V, somit sind die MOSFETs 46 sperrend. Durch die negative Spannung zwischen L und N kann ein Strom 62 entlang des gestrichelt markierten Pfades fließen. Die zweite Diode D2 und die Bodydiode 44 des ersten Transistors Q1 sind in Flussrichtung. Beim Widerstand R handelt es sich um einen hochohmigen Widerstand, der sich wie eine Stromquelle verhält.

Wenn der Halbleiterschalter 38 leiten soll, muss der Schalter 58 zwischen Gate und Source sperrend sein. In Fig. 10 wird dieser Umstand durch den Doppelstrich 64 am offenen Ende des Schalters 58 verdeutlicht. Aufgrund der negativen Spannung zwischen L und N kann Strom 62 durch die gestrichelt markierten Pfade fließen.

Sollte der Halbleiterschalter 38 zuvor sperrend gewesen sein, ist der Ablauf wie folgt:
- C ist entladen (U_{GS} = 0 V)
- Schalter 58 zwischen Gate und Source ist sperrend
- Netzspannung erreicht Nulldurchgang (U_{LN} wechselt von positiv zu negativ)
- Zunächst sind beide Transistoren Q1, Q2 noch sperrend
- Mit abnehmender Spannung U_{LN} kann ein Strom von N über den Widerstand R, den zweiten Transistor Q2, den Kondensator C und die Bodydiode 44 des ersten Transistors Q1 zur Leitung L fließen
- Dabei wird der Kondensator C geladen
- Bei Erreichen der Zenerspannung der ersten Diode D1 endet die Ladephase und der Strom wird durch den Widerstand R begrenzt
- Das Laden des Kondensators C ist gleichbedeutend mit einem Erhöhen von U_{GS}
- U_{GS} ist ausreichend hoch, so dass die Transistoren Q1, Q2 im ohmschen Bereich sind
- Damit ist der Halbleiterschalter 38 leitend und ein zweiter Strompfad durch die Last L und beide Transistoren Q1, Q2 existiert bis auf weiteres

Wenn die Netzspannung in der positiven Phase 54 ist (gestrichelte Umrahmung), kann der Halbleiterschalter 38 ebenfalls leitend oder sperrend sein. Um leitend zu sein, muss der Halbleiterschalter 38 allerdings in der vorherigen (negativen, doppelt-gestrichelten) Phase bereits leitend gewesen sein. Während der positiven Phase 54 kann der Halbleiterschalter 38 der gezeigten Ausführungsform nicht vom sperrenden in den leitenden Zustand überführt werden.

Wenn der Halbleiterschalter 38 in der negativen Phase 56 leitend war, ist die Kapazität - Kondensator C - aufgeladen. In der positiven Phase 54 ist kein Stromfluss von N nach L über den Widerstand R und die Dioden D2 und D1 möglich, sodass der Kondensator C für Spannungsstetigkeit sorgen muss. Der Kondensator C entlädt sich langsam über die erste Diode D1 und muss in der darauffolgenden negativen Phase 56 wieder nachgeladen werden. Damit sich der Kondensator C nicht Richtung N entlädt, sperrt die zweite Diode D2. Das ist durch den Doppelstrich 64 an der Kathode der zweiten Diode D2 in Fig. 9 gekennzeichnet. Während der positiven Halbschwingung 54 von U_{LN} werden die Transistoren Q1, Q2 also durch die zuvor aufgeladene Kapazität C im leitenden Zustand gehalten. Entlang des gestrichelt gezeigten Pfades kann Strom 62 fließen. Fig. 9 zeigt die Schaltung von Fig. 6 während der positiven Halbschwingung im leitenden Zustand der Transistoren Q1, Q2 mit dem Stromfluss 62 über den ersten Transistor Q1 und die Bodydiode 44 des zweiten Transistors Q2.

Wenn der Halbleiterschalter 38 während der positiven Phase 54 sperren soll, muss der Schalter 58 zwischen Gate und Source leitend sein. Dadurch wird U_{GS} = 0 V und die Transistoren Q1, Q2 sperren.

In der gesamten Schaltung fließt kein Strom. U_{LN} liegt in Sperrrichtung über der Bodydiode 44 des ersten Transistors Q1 an, sodass diese sperrt. Das sperrende Verhalten von Bodydiode 44 und erstem Transistor Q1 ist durch die zwei Doppelstriche 64 in Fig. 7 gekennzeichnet.

Zur Verbesserung eines zuverlässigen Schaltens ist eine Ladebrückensteuerung (14) vorgeschlagen worden zum Steuern einer Ladebrücke (12), welche einen Elektromotor (22) aufweist, wobei die Ladebrückensteuerung (14) einen Prozessor (28) aufweist und dazu eingerichtet ist, Bewegungsabläufe der Ladebrücke (12) in Abhängigkeit von Benutzereingaben zu steuern, und eine Schalteinrichtung (34) zum Ein- und Ausschalten des Elektromotors (22) aufweist, wobei die Schalteinrichtung (34) einen Halbleiterschalter (38) mit antiseriell verschalteten Leistungstransistoren (Q1, Q2) aufweist.

### Bezugszeichenliste:

- 10: Ladebrückenanordnung
- 12: Ladebrücke
- 14: Ladebrückensteuerung
- 16: Ladebrückenantrieb
- 18: Plattform
- 20: Lippe
- 22: Elektromotor
- 24: Benutzerschnittstelle
- 26: Bedienelement
- 28: Prozessor
- 30: Versorgungsspannungsanschluss (Wechselstromquelle)
- 32: Motoranschluss
- 34: Schalteinrichtung
- 36: Spannungssensor
- 38: Halbleiterschalter
- 40: Stromsensor
- 44: Bodydiode
- 46: MOSFET
- 48: Last
- 50: Treiberschaltung
- 52: Back-to-Back-Schaltung
- 53: Überprüfungseinrichtung
- 54: positive Halbschwingung
- 56: negative Halbschwingung
- 58: Schalter
- 59: potentialfreier Kontakt, mit Prozessor 28 verbunden
- 60: leitender Zustand des Schalters 58
- 62: Strom-Fluss
- 64: Sperre
- D: Drain
- D1: erste Diode (Zenerdiode)
- D2: zweite Diode
- G: Gate
- L1: erste Phase Versorgungsspannung
- L2: zweite Phase Versorgungsspannung
- L3: dritte Phase Versorgungsspannung
- L: Außenleiter Versorgungsspannung
- N: Neutralleiter
- Q1: erster Transistor (Leistungstransistor)
- Q2: zweiter Transistor (Leistungstransistor)
- R: Widerstand
- S: Source

## Patentansprüche

1. Ladebrückensteuerung (14) zum Steuern einer Ladebrücke (12), welche einen Elektromotor (22) aufweist, wobei die Ladebrückensteuerung (14) einen Prozessor (28) aufweist und dazu eingerichtet ist, Bewegungsabläufe der Ladebrücke (12) in Abhängigkeit von Benutzereingaben zu steuern, und eine Schalteinrichtung (34) zum Ein- und Ausschalten des Elektromotors (22) aufweist, wobei die Schalteinrichtung (34) einen Halbleiterschalter (38) mit antiseriell verschalteten Leistungstransistoren (Q1, Q2) aufweist.

2. Ladebrückensteuerung (14) nach Anspruch 1, **dadurch gekennzeichnet, dass** die Ladebrückensteuerung (14) dazu eingerichtet ist, die Funktion des Halbleiterschalters (38) vor und/oder nach jeder Betätigung desselben zu überprüfen.

3. Ladebrückensteuerung (14) nach Anspruch 2, **dadurch gekennzeichnet, dass** eine Überprüfungseinrichtung (53) zur Funktionsüberprüfung des Halbleiterschalters (38) vorgesehen ist, die einen Spannungssensor (36) zum Messen einer Spannung an dem Halbleiterschalter (38) und/oder einen Stromsensor (40) zum Messen eines durch den Halbleiterschalter (38) laufenden Stroms aufweist.

4. Ladebrückensteuerung (14) nach einem der Ansprüche 2 oder 3, **dadurch gekennzeichnet,**
**dass** die Ladebrückensteuerung (14) weiter dazu eingerichtet ist, nach festgestellter Fehlfunktion automatisch ein erneutes Betätigen des Halbleiterschalters (38) zu verhindern.

5. Ladebrückensteuerung (14) nach einem der voranstehenden Ansprüche, dass die antiseriell verschalteten Leistungstransistoren (q1, Q2) back-to-back verschaltete n-Kanal-Mosfets (46) sind.

6. Ladebrückensteuerung (14) nach einem der voranstehenden Ansprüche, **dadurch gekennzeichnet,**
**dass** für jede Phase (u, v, w) des Elektromotors (22) ein Halbleiterschalter (38) oder ein Zweig des Halbleiterschalters (38) mit antiseriell verschalteter Leistungstransistoren (Q1, Q2) vorgesehen sind.

7. Ladebrückensteuerung (14) nach einem der voranstehenden Ansprüche, **dadurch gekennzeichnet,**
**dass** der Halbleiterschalter (38) eine Treiberschaltung (50) für die Leistungstransistoren (Q1, Q2) mit einem durch den Prozessor betätigbaren Schalter (58) aufweist.

8. Ladebrückensteuerung (14) nach Anspruch 7, **dadurch gekennzeichnet, dass** die Treiberschaltung (50) einen durch die Wechselstromquelle, mit der der Elektromotor (22) mittels der Schalteinrichtung (34) verbindbar ist, aufladbaren Kondensator (C) aufweist, der im geladenen Zustand eine Steuerspannung zum Schalten der Leistungstransistoren (Q1, Q2) liefert.

9. Ladebrückensteuerung (14) nach Anspruch 8, **dadurch gekennzeichnet, dass** einer der antiseriell verschalteten Leistungstransistoren mit der Wechselstromquelle verbunden ist und der andere mit der zugeordneten Phase des Elektromotors (22) verbunden ist,
dass die Treiberschaltung (50) den parallel zu dem Schalter geschalteten Kondensator (C), eine parallel dazu geschaltete als Zenerdiode ausgebildete erste Diode (D1), einen Widerstand (R) und eine zweite Diode (D2) aufweist, wobei der Widerstand (R) und die entgegengerichtet zu der ersten Diode (D1) wirkende zweite Diode (D2) in Serie zwischen einem Eingang des Schalters (58) und einem Neutralleiter (N) geschaltet sind, wobei der Eingang des Schalters (58) mit den Gates der Leistungstransistoren (Q1, Q2) verbunden ist und der Ausgang des Schalters (58) mit der Verbindung zwischen den Leistungstransistoren (Q1, Q2) verbunden ist.

10. Ladebrückenanordnung (10), umfassend eine Ladebrücke (12) mit einem Ladebrückenantrieb (16), der einen Drehstrommotor (22) umfasst, und eine Ladebrückensteuerung (14) nach einem der voranstehenden Ansprüche.

11. Verfahren zum Betrieb einer Ladebrücke (12), die durch einen Ladebrückenantrieb (16), der einen Drehstrommotor (22) umfasst, angetrieben wird, wobei der Ladebrückenantrieb (16) durch eine Ladebrückensteuerung (14) nach einem der Ansprüche 1 bis 9 gesteuert wird, wobei der Drehstrommotor mittels des Halbleiterschalters (38) mit einer Wechselstromquelle verbunden wird und davon getrennt wird.
